(19)

**Europäisches Patentamt**

**European Patent Office**

**Office européen des brevets**

(11)  **EP 4 303 601 B1**

(12)  **EUROPEAN PATENT SPECIFICATION**

(45) Date of publication and mention
of the grant of the patent:
**25.02.2026  Bulletin 2026/09**

(21) Application number: **21932191.6**

(22) Date of filing: **25.03.2021**

(51) International Patent Classification (IPC):
**G01R 31/396** *(2019.01)*      **G01R 31/387** *(2019.01)*

(52) Cooperative Patent Classification (CPC):
**H02J 7/82; H02J 3/32; H02J 7/52;** G01R 31/387;
G01R 31/396; Y02E 60/10

(86) International application number:
**PCT/CN2021/082991**

(87) International publication number:
**WO 2022/198564 (29.09.2022 Gazette 2022/39)**

(54)  **ENERGY STORAGE SYSTEM CONTROL METHOD AND ENERGY STORAGE SYSTEM**

ENERGIESPEICHERSYSTEMSTEUERUNGSVERFAHREN UND ENERGIESPEICHERSYSTEM

PROCÉDÉ DE COMMANDE DE SYSTÈME DE STOCKAGE D'ÉNERGIE ET SYSTÈME DE
STOCKAGE D'ÉNERGIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.01.2024  Bulletin 2024/02**

(73) Proprietor: **Huawei Digital Power Technologies
Co., Ltd.
Shenzhen, Guangdong 518043 (CN)**

(72) Inventors:
• **WU, Zhipeng
Shenzhen, Guangdong 518129 (CN)**
• **HU, Yang
Shenzhen, Guangdong 518129 (CN)**

• **ZHOU, He
Shenzhen, Guangdong 518129 (CN)**
• **YU, Shijiang
Shenzhen, Guangdong 518129 (CN)**

(74) Representative: **Gill Jennings & Every LLP
The Broadgate Tower
20 Primrose Street
London EC2A 2ES (GB)**

(56) References cited:
EP-A1- 2 916 417          CN-A- 103 259 055
CN-A- 106 849 212          CN-A- 109 633 459
CN-A- 111 585 356          US-A1- 2017 212 203
US-A1- 2017 345 101          US-A1- 2021 083 505
US-B2- 7 476 987

## Description

### TECHNICAL FIELD

This application relates to the field of energy storage technologies, and more specifically, to a method for controlling an energy storage system and an energy storage system.

### BACKGROUND

At present, a battery management system (BMS) uses an ampere-hour integral method to estimate a state of charge (SOC) of a battery. To be specific, a battery charge or discharge current A is measured, an accumulated charge/discharge capacity Ah is counted by hour h, and the accumulated charge/discharge capacity Ah is added to an initial capacity to obtain a current remaining battery capacity.

However, due to factors such as precision problems of components such as a current sensor and an adjustment circuit, an error in current sampling, a time-varying property of a battery operating current, and possible high-frequency or low-frequency harmonics, if a current sampling frequency is not high enough, a sampling deviation is caused, and SOC accuracy of an energy storage system estimated by the BMS gradually decreases as a system running time increases.

In a general energy storage scenario, the energy storage system is fully charged and fully discharged once regularly, and the SOC is calibrated based on a voltage at an end of charge or discharge. However, in a frequency modulation scenario, the energy storage system performs a charge or discharge action based on an automatic generation control (AGC) scheduling instruction. A single AGC scheduling instruction usually takes no more than 5 min, a probability of charging amounts to a probability of discharging, and there is a low probability that only charging or discharging is performed for a long time. Consequently, in such a manner, the energy storage system works in a battery voltage platform area for a long time, few full charge or full discharge conditions satisfy SOC calibration, the SOC is not calibrated for a long time, and the SOC accuracy is increasingly low. When the SOC accuracy is low, SOC-based control becomes infeasible, and a SOC value is of little significance.

Therefore, how to implement SOC calibration for an energy storage system becomes a problem to be urgently resolved in the industry.

US2021/0083505A1 discloses a microgrid power system for providing power to residences and businesses

US2017/345101A1 discloses an electrical energy storage unit and control system.

### SUMMARY

This application provides a method for controlling an energy storage system and an energy storage system, to implement online SOC calibration of the energy storage system without affecting normal running of the energy storage system. The invention is defined by the features of the independent claims. Preferred embodiments are defined in the dependent claims.

According to a first aspect, a method for controlling an energy storage system is provided. The energy storage system includes a plurality of battery clusters, a plurality of direct current/direct current converters, and a controller, the plurality of battery clusters are in a one-to-one correspondence with the plurality of direct current/direct current converters, so that the controller individually controls each of the plurality of battery clusters, the method is performed by the controller, and the method includes: determining that a first battery cluster in the plurality of battery clusters needs to be calibrated; and controlling, based on a state of charge SOC of the first battery cluster and a current charging or discharging state of the energy storage system, the first battery cluster to be charged or discharged or to be in a standby state, so that the first battery cluster satisfies a SOC calibration condition.

In this application, the controller determines that the first battery cluster in the plurality of battery clusters needs to be calibrated, and then controls, based on the state of charge SOC of the first battery cluster and the current charging or discharging state of the energy storage system, the first battery cluster to be charged or discharged or to be in a standby state, so that the first battery cluster satisfies the SOC calibration condition. In this way, charging, discharging, or standby-state control needs to be performed on only one battery cluster that needs to be calibrated in the energy storage system, independent decoupling management is implemented on the battery cluster, running of the energy storage system does not need to exist, and normal running of the energy storage system is not affected. This enables the battery cluster to quickly satisfy the SOC calibration condition, and implements online SOC calibration of the energy storage system. In addition, according to the technical solution of this application, online SOC calibration may be performed in turn on all battery clusters that need to be calibrated in the energy storage system, so that overall SOC accuracy of the energy storage system can be improved.

Optionally, the battery cluster may be a battery cluster or another unit that can store energy.

Optionally, the controller may be an energy management system (EMS) or a smart array control unit (SACU).

The SOC calibration condition is a fully charged/fully discharged state.

With reference to the first aspect, the controlling, based on a state of charge SOC of the first battery cluster and a current charging or discharging state of the energy storage system, the first battery cluster to be charged or discharged or to be in a standby state includes: if the SOC of the first battery cluster is greater than or equal to a first threshold, when the energy storage system is in a charging state, controlling the first battery cluster to be charged, and when the energy storage system is in a discharging state, controlling the first battery cluster to be in a standby state until the energy storage system is in a charging state; or if the SOC of the first battery cluster is less than the first threshold, when the energy storage system is in a discharging state, controlling the first battery cluster to be discharged, and when the energy storage system is in a charging state, controlling the first battery cluster to be in a standby state until the energy storage system is in a discharging state.

Optionally, the first threshold may be 50%.

Whether the state of charge SOC of the first battery cluster is greater than or equal to the first threshold can be determined, to determine how to control the first battery cluster so that the battery cluster can quickly satisfy the SOC calibration condition. If the SOC of the first battery cluster is greater than or equal to the first threshold, when the energy storage system is in a charging state, the first battery cluster is controlled to be charged, and when the energy storage system is in a discharging state, the first battery cluster is controlled to be in a standby state until the energy storage system is in a charging state. If the SOC of the first battery cluster is less than the first threshold, when the energy storage system is in a discharging state, the first battery cluster is controlled to be discharged, and when the energy storage system is in a charging state, the first battery cluster is controlled to be in a standby state until the energy storage system is in a discharging state. In this way, the first battery cluster can quickly satisfy the SOC calibration condition.

With reference to the first aspect, the controlling the first battery cluster to be charged includes: controlling the first battery cluster to be charged with a charging power greater than a charging power in a normal working mode of the energy storage system, where the charging power in the normal working mode is a charging power used when the energy storage system performs power allocation based on SOCs of the plurality of battery clusters; or the controlling the first battery cluster to be discharged includes: controlling the first battery cluster to be discharged with a discharging power greater than a discharging power in a normal working mode of the energy storage system, where the discharging power in the normal working mode is a discharging power used when the energy storage system performs power allocation based on SOCs of the plurality of battery clusters.

The first battery cluster is controlled to be charged with the charging power greater than the charging power in the normal working mode of the energy storage system, or the first battery cluster is controlled to be discharged with the discharging power greater than the discharging power in the normal working mode of the energy storage system, so that the first battery cluster can be charged or discharged with the power greater than the power in the normal working mode, thereby quickly satisfying the SOC calibration condition.

With reference to the first aspect, in some implementations of the first aspect, the controlling the first battery cluster to be charged includes: controlling the first battery cluster to be charged with a maximum charging power of the energy storage system, where the maximum charging power is greater than the charging power in the normal working mode and is a maximum power calculated by a battery management system BMS of the energy storage system; or the controlling the first battery cluster to be discharged includes: controlling the first battery cluster to be discharged with a maximum discharging power of the energy storage system, where the maximum discharging power is greater than the discharging power in the normal working mode and is a maximum power calculated by a battery management system BMS of the energy storage system.

The first battery cluster is controlled to be charged with the maximum charging power calculated by the battery management system BMS of the energy storage system, or the first battery cluster is controlled to be discharged with the maximum discharging power calculated by the BMS of the energy storage system, so that the first battery cluster can be charged or discharged with the maximum power calculated by the BMS, thereby quickly satisfying the SOC calibration condition.

With reference to the first aspect, in some implementations of the first aspect, the determining that a first battery cluster in the plurality of battery clusters needs to be calibrated includes: receiving an accumulated running time Tr of the first battery cluster starting from a previous SOC calibration time point and an accumulated non-running time Td of the first battery cluster starting from the previous SOC calibration time point, where Tr and Td are sent by the BMS of the energy storage system; and determining, based on Tr and Td, that the first battery cluster needs to be calibrated.

By receiving the accumulated running time Tr of the first battery cluster starting from the previous SOC calibration time point and the accumulated non-running time Td of the first battery cluster starting from the previous SOC calibration time point, where Tr and Td are sent by the BMS of the energy storage system, the controller can determine, based on Tr and Td, that the first battery cluster needs to be calibrated, so that the charging and discharging power of the first battery cluster can be controlled. This enables the first battery cluster to quickly satisfy the SOC calibration condition.

With reference to the first aspect, in some implementations of the first aspect, the determining, based on Tr and Td, that the first battery cluster needs to be calibrated includes: if the accumulated running time Tr is greater than or equal to a time Ts, determining that the first battery cluster is an battery cluster that needs to be calibrated; or if the accumulated non-running time Td is greater than or equal to a time Tp, determining that the battery cluster is an battery cluster that needs to be calibrated.

Whether Tr is greater than or equal to Ts or whether Td is greater than or equal to Tp can be determined, to determine whether the battery cluster is an battery cluster that needs to be calibrated, so as to determine whether to individually control a charging, discharging, or standby working mode of the battery cluster.

With reference to the first aspect, in some implementations of the first aspect, when a plurality of battery clusters are battery clusters that need to be calibrated, it is determined, based on a priority sequence, that the first battery cluster needs to be calibrated.

Based on the priority sequence, the first battery cluster is determined for the plurality of battery clusters that need to be calibrated, so that the controller can preferentially control the charging, discharging, or standby working mode of the first battery cluster.

With reference to the first aspect, in some implementations of the first aspect, the method further includes: when the first battery cluster satisfies the SOC calibration condition, indicating the BMS of the energy storage system to perform SOC calibration on the first battery cluster.

When the first battery cluster satisfies the SOC calibration condition, the BMS of the energy storage system is indicated to perform SOC calibration on the first battery cluster, to implement the SOC calibration performed on the first battery cluster.

With reference to the first aspect, in some implementations of the first aspect, the method further includes: receiving a notification that is sent by the BMS and that indicates that the SOC calibration performed on the first battery cluster is completed ; and controlling the first battery cluster to be charged or discharged or to be in a standby state in the normal working mode of the energy storage system, wherein the normal working mode is a mode in which the energy storage system performs power allocation based on the SOCs of the plurality of battery clusters.

After receiving the notification that is sent by the BMS and that indicates that the SOC calibration performed on the first battery cluster is completed, the controller controls the first battery cluster to be charged or discharged or to be in a standby state in the normal working mode of the energy storage system, so that the controller can end individual control on the first battery cluster, and the controller can control another battery cluster that needs to be calibrated to be charged or discharged or to be in a standby state. In this way, the another battery cluster that needs to be calibrated satisfies the SOC calibration condition.

According to a second aspect, an energy storage system is provided. The energy storage system includes a plurality of battery clusters, a plurality of direct current/direct current converters, a controller, and a battery management system BMS, and the plurality of battery clusters are in a one-to-one correspondence with the plurality of direct current/direct current converters, so that the controller individually controls each of the plurality of battery clusters; the BMS is configured to: obtain states of charge SOCs of the plurality of battery clusters, and send the SOCs of the plurality of battery clusters to the controller; the controller is configured to: determine that a first battery cluster in the plurality of battery clusters needs to be calibrated; and the controller is further configured to control, based on a state of charge SOC of the first battery cluster and a current charging or discharging state of the energy storage system, the first battery cluster to be charged or discharged or to be in a standby state, so that the first battery cluster satisfies a SOC calibration condition.

In this application, the controller determines that the first battery cluster in the plurality of battery clusters needs to be calibrated, and then controls, based on the state of charge SOC of the first battery cluster and the current charging or discharging state of the energy storage system, the first battery cluster to be charged or discharged or to be in a standby state, so that the first battery cluster satisfies the SOC calibration condition. In this way, charging, discharging, or standby-state control needs to be performed on only one battery cluster that needs to be calibrated in the energy storage system, independent decoupling management is implemented on the battery cluster, running of the energy storage system does not need to exist, and normal running of the energy storage system is not affected. This enables the battery cluster to quickly satisfy the SOC calibration condition, and implements online SOC calibration of the energy storage system. In addition, according to the technical solution of this application, online SOC calibration may be performed in turn on all battery clusters that need to be calibrated in the energy storage system, so that overall SOC accuracy of the energy storage system can be improved.

Optionally, the battery cluster may be a battery cluster or another unit that can store energy.

Optionally, the controller may be an EMS or an SACU.

The SOC calibration condition is a fully charged/fully discharged state.

With reference to the second aspect, the controller is configured to: if the SOC of the first battery cluster is greater than or equal to a first threshold, when the energy storage system is in a charging state, control the first battery cluster to be charged, and when the energy storage system is in a discharging state, control the first battery cluster to be in a standby state until the energy storage system is in a charging state; or if the SOC of the first battery cluster is less than the first threshold, when the energy storage system is in a discharging state, control the first battery cluster to be discharged, and when the energy storage system is in a charging state, control the first battery cluster to be in a standby state until the energy storage system is in a discharging state.

Optionally, the first threshold may be 50%.

Whether the state of charge SOC of the first battery cluster is greater than or equal to the first threshold can be determined, to determine how to control the first battery cluster so that the battery cluster can quickly satisfy the SOC calibration condition. If the SOC of the first battery cluster is greater than or equal to the first threshold, when the energy storage system is in a charging state, the first battery cluster is controlled to be charged, and when the energy storage system is in a discharging state, the first battery cluster is controlled to be in a standby state until the energy storage system is in a charging state. If the SOC of the first battery cluster is less than the first threshold, when the energy storage system is in a discharging state, the first battery cluster is controlled to be discharged, and when the energy storage system is in a charging state, the first battery cluster is controlled to be in a standby state until the energy storage system is in a discharging state. In this way, the first battery cluster can quickly satisfy the SOC calibration condition.

With reference to the second aspect, the controller is configured to: control the first battery cluster to be charged with a charging power greater than a charging power in a normal working mode of the energy storage system, where the charging power in the normal working mode is a charging power used when the energy storage system performs power allocation based on the SOCs of the plurality of battery clusters; or the controller is configured to: control the first battery cluster to be discharged with a discharging power greater than a discharging power in a normal working mode of the energy storage system, where the discharging power in the normal working mode is a discharging power used when the energy storage system performs power allocation based on the SOCs of the plurality of battery clusters.

The first battery cluster is controlled to be charged with the charging power greater than the charging power in the normal working mode of the energy storage system, or the first battery cluster is controlled to be discharged with the discharging power greater than the discharging power in the normal working mode of the energy storage system, so that the first battery cluster can be charged or discharged with the power greater than the power in the normal working mode, thereby quickly satisfying the SOC calibration condition.

With reference to the second aspect, in some implementations of the second aspect, the controller is configured to: control the first battery cluster to be charged with a maximum charging power of the energy storage system, where the maximum charging power is greater than the charging power in the normal working mode and is a maximum power calculated by the BMS; or the controller is configured to: control the first battery cluster to be discharged with a maximum discharging power of the energy storage system, where the maximum discharging power is greater than the discharging power in the normal working mode and is a maximum power calculated by the BMS.

The first battery cluster is controlled to be charged with the maximum charging power calculated by the battery management system BMS of the energy storage system, or the first battery cluster is controlled to be discharged with the maximum discharging power calculated by the BMS of the energy storage system, so that the first battery cluster can be charged or discharged with the maximum power calculated by the BMS, thereby quickly satisfying the SOC calibration condition.

With reference to the second aspect, in some implementations of the second aspect, the BMS is further configured to send, to the controller, an accumulated running time Tr of the first battery cluster starting from a previous SOC calibration time point and an accumulated non-running time Td of the first battery cluster starting from the previous SOC calibration time point; the controller is further configured to receive Tr and Td that are sent by the BMS of the energy storage system; and the controller is further configured to determine, based on Tr and Td, that the first battery cluster needs to be calibrated.

By receiving the accumulated running time Tr of the first battery cluster starting from the previous SOC calibration time point and the accumulated non-running time Td of the first battery cluster starting from the previous SOC calibration time point, where Tr and Td are sent by the BMS of the energy storage system, the controller can determine, based on Tr and Td, that the first battery cluster needs to be calibrated, so that the charging and discharging power of the first battery cluster can be controlled. This enables the first battery cluster to quickly satisfy the SOC calibration condition.

With reference to the second aspect, in some implementations of the second aspect, the controller is configured to: if the accumulated running time Tr is greater than or equal to a time Ts, determining that the first battery cluster is an battery cluster that needs to be calibrated; or if the accumulated non-running time Td is greater than or equal to a time Tp, determining that the battery cluster is an battery cluster that needs to be calibrated.

Whether Tr is greater than or equal to Ts or whether Td is greater than or equal to Tp can be determined, to determine whether the battery cluster is an battery cluster that needs to be calibrated, so as to determine whether to individually control a charging, discharging, or standby working mode of the battery cluster.

With reference to the second aspect, in some implementations of the second aspect, when a plurality of battery clusters are battery clusters that need to be calibrated, the controller determines, based on a priority sequence, that the first battery cluster needs to be calibrated.

Based on the priority sequence, the first battery cluster is determined for the plurality of battery clusters that need to be calibrated, so that the controller can preferentially control the charging, discharging, or standby working mode of the first battery cluster.

With reference to the second aspect, in some implementations of the second aspect, the controller is further configured to: when the first battery cluster satisfies the SOC calibration condition, indicate the BMS of the energy storage system to perform SOC calibration on the first battery cluster.

When the first battery cluster satisfies the SOC calibration condition, the BMS of the energy storage system is indicated to perform SOC calibration on the first battery cluster, to implement the SOC calibration performed on the first battery cluster.

With reference to the second aspect, in some implementations of the second aspect, the controller is further configured to receive a notification that is sent by the BMS and that indicates that the SOC calibration performed on the first battery cluster is completed; and the controller is further configured to control the first battery cluster to be charged or discharged or to be in a standby state in the normal working mode of the energy storage system, where the normal working mode is a mode in which the energy storage system performs power allocation based on the SOCs of the plurality of battery clusters.

After receiving the notification that is sent by the BMS and that indicates that the SOC calibration performed on the first battery cluster is completed, the controller controls the first battery cluster to be charged or discharged or to be in a standby state in the normal working mode of the energy storage system, so that the controller can end individual control on the first battery cluster, and the controller can control another battery cluster that needs to be calibrated to be charged or discharged or to be in a standby state. In this way, the another battery cluster that needs to be calibrated satisfies the SOC calibration condition.

## BRIEF DESCRIPTION OF DRAWINGS

FIG. 1 is a schematic diagram of an energy storage system according to this application;
FIG. 2 is a diagram of an architecture of an energy storage system according to this application;
FIG. 3 is a diagram of another architecture of an energy storage system according to this application;
FIG. 4 is a diagram of still another architecture of an energy storage system according to this application;
FIG. 5 is a diagram of an architecture of an energy storage system according to this application;
FIG. 6 is a schematic diagram of a method for controlling an energy storage system according to this application; and
FIG. 7A to FIG. 7C are a schematic flowchart of a method for controlling an energy storage system according to this application.

## DESCRIPTION OF EMBODIMENTS

The following describes technical solutions of this application with reference to the accompanying drawings.

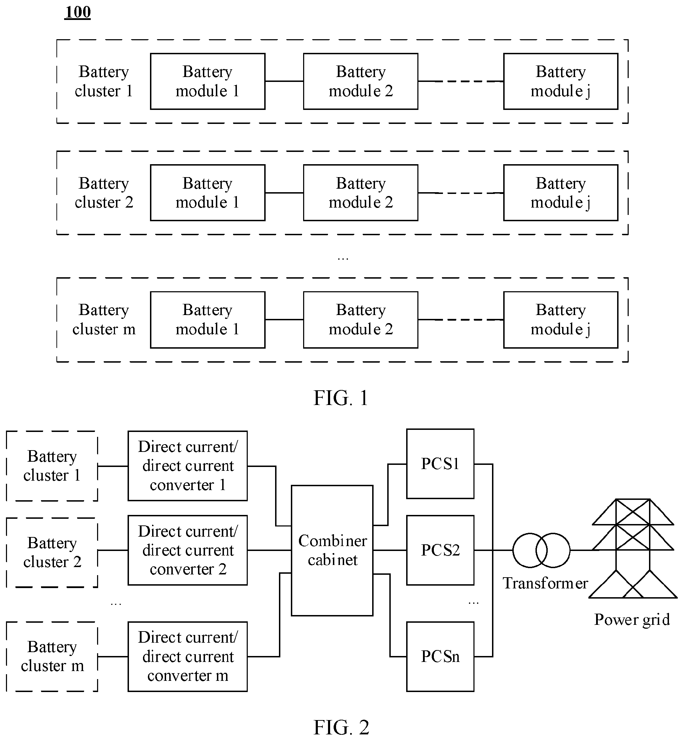

FIG. 1 is a schematic diagram of an energy storage system according to this application.

The energy storage system includes at least one battery cluster, for example, a battery cluster 1 to a battery cluster m that are shown in FIG. 1, where m may be a natural number greater than 0. In other words, in actual application, a quantity of battery clusters can be flexibly adjusted based on an energy storage capacity. The quantity of battery clusters can be appropriately increased if the energy storage capacity is large, or the quantity of battery clusters can be appropriately reduced if the energy storage capacity is small.

It should be understood that in the energy storage system shown in FIG. 1, the battery cluster may be presented in a form of a battery cluster, or may be presented in a form of another unit that can store energy. This is not limited in this application. For ease of description, the technical solution of this application is described in which the battery cluster is in a form of a battery cluster in this application.

Each battery cluster includes at least two battery modules connected in series, for example, a battery module 1 to a battery module j in FIG. 1, where j may be a natural number greater than or equal to 2. Each battery module includes several energy storage elements connected in series or in parallel to form a smallest energy storage and management unit. To implement detection and control on the energy storage system, a battery management system BMS is designed in each battery module to monitor battery information such as a SOC, a temperature, and a current, and the BMS exchanges information with an upper-layer EMS or SACU in real time to effectively manage and control the entire battery energy storage system.

In this embodiment of this application, decoupling management is performed on each battery cluster, that is, each battery cluster may be individually controlled. When there is at least one battery cluster on which SOC calibration needs to be performed in a plurality of battery clusters, the battery cluster on which SOC calibration needs to be performed is individually controlled without affecting normal running of the energy storage system.

With reference to FIG. 2 to FIG. 5, the following first describes an energy storage system provided in this application.

FIG. 2 is a diagram of an architecture of an energy storage system according to this application.

Specifically, as shown in FIG. 2, battery modules are connected in series in a manner shown in FIG. 1 to form a battery cluster, and the battery cluster is connected to one port of a bidirectional direct current/direct current converter, and the other port of the bidirectional direct current/direct current converter is connected to a direct current bus (DC BUS).

The architecture shown in FIG. 2 includes m battery clusters in total. Each battery cluster is correspondingly connected to one bidirectional direct current/direct current converter and a direct current bus DC BUS, and the battery cluster exchanges energy with the DC BUS by using the bidirectional direct current/direct current converter.

It should be understood that in the architecture shown in FIG. 2, in a manner in which each battery cluster is correspondingly connected to one bidirectional direct current/direct current converter, the battery clusters can be controlled independently of each other, to implement independent decoupling management for single-cluster running of the battery clusters, effectively avoid a buckets effect between the battery clusters, and implement normal running of the energy storage system.

After the m battery clusters and m direct current/direct current converters are correspondingly connected in series in a one-to-one manner, the m battery clusters are converged to one port of a direct current combiner cabinet shown in FIG. 2. The other port of the combiner cabinet is connected to direct current sides of n power conversion systems (PCSs), and n is a natural number greater than 0. Alternating current sides of the n PCSs are connected to a low-voltage side of a transformer, and a high-voltage side of the transformer is connected to a power grid.

The combiner cabinet can converge and distribute currents on the DC BUS. When a power of a single direct current/direct current converter is inconsistent with that of a single PCS, a power of an alternating current side can overall match a power of a direct current side by configuring a corresponding quantity of PCSs.

It should be understood that the combiner cabinet shown in FIG. 2 is not mandatory. When there is no combiner cabinet, in this application, a function of a combiner cabinet may be equivalently implemented by connecting direct current buses in parallel or in another manner. This is not limited in this application.

It should also be understood that the n PCSs shown in FIG. 2 can be connected in parallel to a low-voltage side of a double-winding transformer, and can also be divided into two or more groups and connected in parallel to a plurality of low-voltage buses of a three-winding double-split transformer or another type of multi-winding transformer. In addition, the transformer is not a strongly restricted component in this application. In a low-voltage grid-tied scenario, the transformer may not be needed.

For ease of understanding the technical solution of this application, in this application, that a voltage of a battery module is 57.6 V and there are 20 battery modules connected in series is used as an example instead of a limitation, to further describe the technical solution of this application. When the voltage of the battery module is 57.6 V and there are 20 battery modules connected in series, a port voltage of a battery cluster is $57.6 \times 20 = 1152\ V_{dc}$.

It should be understood that, after the port voltage of the battery cluster is calculated, a matched direct current/direct current converter needs to be selected based on a value of the port voltage. In an example, when the calculated port voltage of the battery cluster is $1152\ V_{dc}$, the matched direct current/direct current converter is a bidirectional DC/DC converter, a voltage ranging from $1000\ V_{dc}$ to $1500\ V_{dc}$ is matched, and the port voltage of the battery cluster is matched with an alternating current voltage ranging from $380\ V_{ac}$ to $800\ V_{ac}$.

It should also be understood that, to implement efficient power conversion, a circuit topology used for the direct current/direct current converter in this embodiment of this application is usually a non-isolated circuit. By way of example rather than limitation, the non-isolation circuit may be a flying capacitor multi-level circuit, a three-level boost circuit, a four-transistor buck-boost circuit, or the like. This is not limited in this application.

It should also be understood that the PCS in this application is a bidirectional DC/AC converter, and may be a three-level T-type neutral point clamped circuit, a neutral point clamped (NPC) circuit, an active neutral point clamped (ANPC) circuit, a flying capacitor multi-level circuit, or the like. In addition, because a port voltage of an energy storage element changes with an energy storage capacity, and the port voltage of the battery cluster is an output voltage in a wide range, to match a change range of the port voltage of the battery cluster, the direct current/direct current converter or the PCS is usually designed to have an input/output capability in a wide range.

By way of example rather than limitation, each of power switching devices of the direct current/direct current converter and the PCS that are used in this embodiment of this application may be a MOSFET or an IGBT.

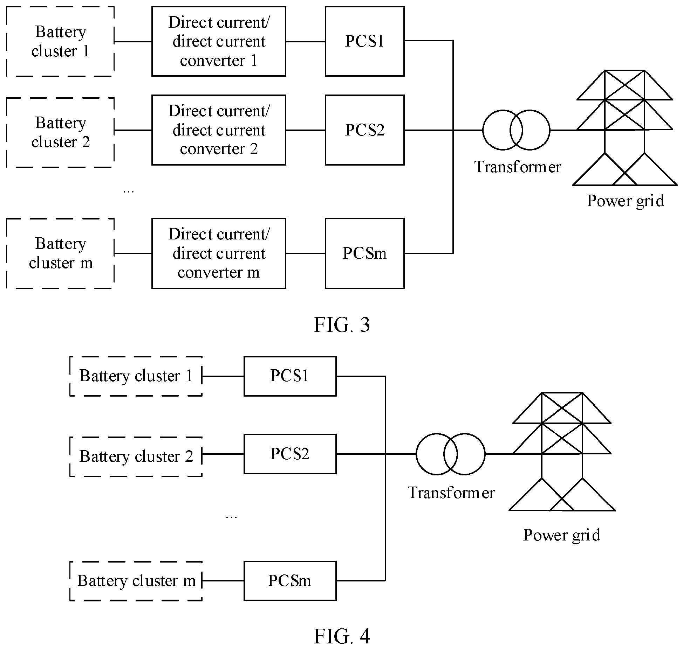

FIG. 3 is a schematic diagram of an architecture of another energy storage system according to this application.

Different from the architecture shown in FIG. 2, the other ends of m direct current/direct current converters shown in FIG. 3 are respectively connected to direct current sides of m PCSs, alternating current sides of the m PCSs are converged to a low-voltage side of a transformer, and a high-voltage side of the transformer is connected to a power grid. The direct current/direct current converters are in a one-to-one correspondence with the PCSs, and a power of the direct current/direct current converter matches that of a single PCS. Output powers of the PCSs may be directly controlled through power scheduling control, and the direct current/direct current converters work in a voltage source mode.

FIG. 4 is a schematic diagram of an architecture of still another energy storage system according to this application.

The architecture shown in FIG. 4 includes m battery clusters in total, where m is a natural number greater than 0. Each battery cluster is connected to one PCS. Alternating current sides of m PCSs are converged to a low-voltage side of a transformer, and a high-voltage side of the transformer is connected to a power grid.

In the architecture shown in FIG. 4, the battery clusters can be controlled independently of each other, to implement independent decoupling management for single-cluster running of the battery clusters, and effectively avoid a buckets effect between the battery clusters. Output powers of the PCSs may be controlled through power scheduling control, to control charging/discharging of the battery clusters.

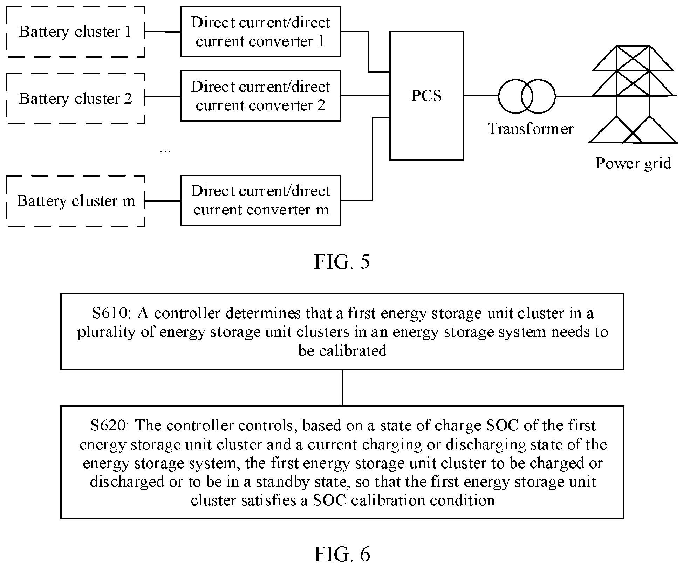

FIG. 5 is a schematic diagram of an architecture of yet another energy storage system according to this application.

It should be understood that in the architecture shown in FIG. 5, each battery cluster is connected to one direct current/direct current converter, the other ends of direct current/direct current converters corresponding to all clusters are jointly connected to a direct current side of one centralized PCS, an alternating current side of the centralized PCS is connected to one side of a transformer, and the other side of the transformer is connected to a power grid. In the architecture shown in FIG. 5, although a plurality of battery clusters are all connected to one PCS, the direct current/direct current converters connected in series to the battery clusters can implement decoupling between the battery clusters, and can also implement individual charging, discharging, or standby-state control.

It should be understood that in the architectures of the energy storage systems shown above, the transformers are not mandatory. In a low-voltage power distribution network access scenario and the like, a voltage level of the power grid is the same as an output voltage level of the PCS, and therefore no transformer may be needed.

FIG. 2 to FIG. 5 show the schematic diagrams of the specific architectures of the four energy storage systems according to this application. It should be understood that in embodiments of this application, the energy storage system may include the following components: a plurality of battery clusters, a plurality of direct current/direct current converters, a controller, and a battery management system BMS. The plurality of battery clusters are in a one-to-one correspondence with the plurality of direct current/direct current converters, so that the controller individually controls each of the plurality of battery clusters.

The battery management system BMS is configured to: obtain states of charge SOCs of the plurality of battery clusters, and send the SOCs of the plurality of battery clusters to the controller.

The controller may be an EMS or an SACU, and the controller is configured to: determine that a first battery cluster in the plurality of battery clusters needs to be calibrated, and control, based on a SOC of the first battery cluster and a current charging or discharging state of the energy storage system, the first battery cluster to be charged or discharged or to be in a standby state, so that the first battery cluster satisfies a SOC calibration condition. The SOC calibration condition may be a fully charged/fully discharged state.

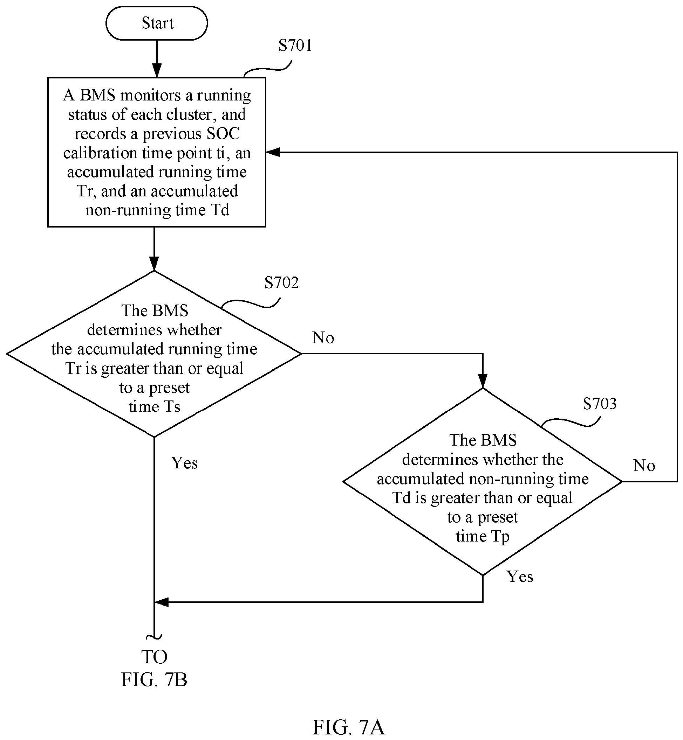

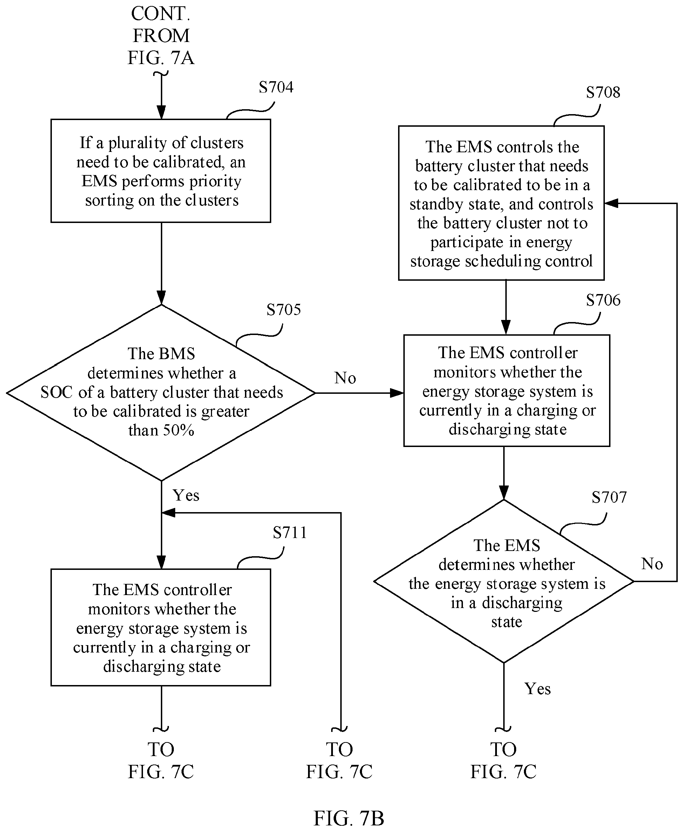

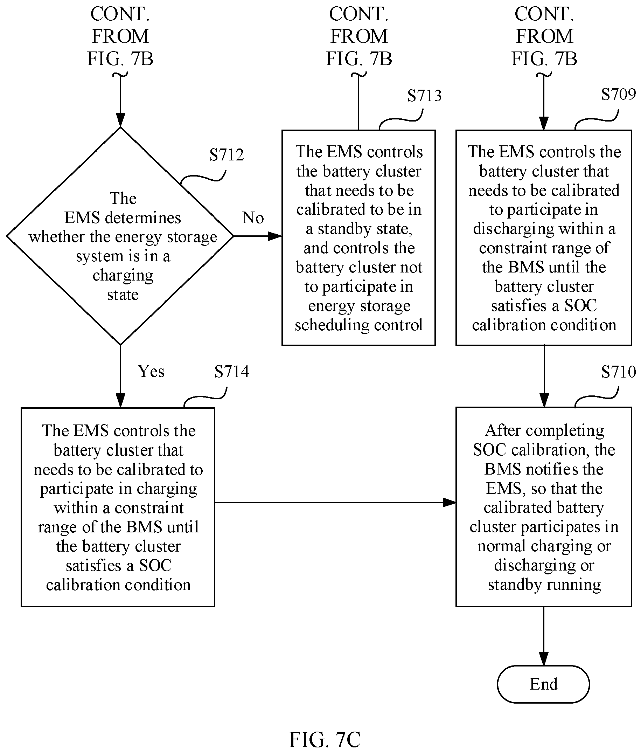

With reference to FIG. 6 and FIG. 7A to FIG. 7C, the following describes a method for controlling an energy storage system provided in this application.

FIG. 6 is a schematic diagram of a method for controlling an energy storage system according to this application. The method is performed by a controller in the energy storage system. The controller may be an EMS or an SACU. This is not limited in this application.

S610: Determine that a first battery cluster in a plurality of battery clusters needs to be calibrated.

S620: Control, based on a state of charge SOC of the first battery cluster and a current charging or discharging state of the energy storage system, the first battery cluster to be charged or discharged or to be in a standby state, so that the first battery cluster satisfies a SOC calibration condition.

It should be understood that in the foregoing technical solution, the controller determines the first battery cluster that needs to be calibrated in the plurality of energy storage units, and obtains the state of charge of the first battery cluster and the charging or discharging state of the energy storage system, to individually control the first battery cluster to be charged or discharged or to be in a standby state, so that the first battery cluster satisfies the SOC calibration condition.

Specific solutions are described as follows:

#a: If the SOC of the first battery cluster is greater than or equal to a first threshold, when the energy storage system is in a charging state, the controller controls the first battery cluster to be charged, and when the energy storage system is in a discharging state, the controller controls the first battery cluster to be in a standby state until the energy storage system is in a charging state.

#b: If the SOC of the first battery cluster is less than the first threshold, when the energy storage system is in a discharging state, the controller controls the first battery cluster to be discharged, and when the energy storage system is in a charging state, the controller controls the first battery cluster to be in a standby state until the energy storage system is in a discharging state.

Optionally, the first threshold may be 50%.

It should be understood that, according to the foregoing technical solution, the first battery cluster can quickly satisfy the SOC calibration condition.

For example, if the first battery cluster needs to be controlled to be charged, the controller controls the first battery cluster to be charged with a charging power greater than a charging power in a normal working mode of the energy storage system; or if the first battery cluster needs to be controlled to be discharged, the controller controls the first battery cluster to be discharged with a discharging power greater than a discharging power in a normal working mode of the energy storage system.

It should be understood that the first battery cluster is controlled to be charged with the charging power greater than the charging power in the normal working mode of the energy storage system, or the first battery cluster is controlled to be discharged with the discharging power greater than the discharging power in the normal working mode of the energy storage system, so that the first battery cluster can be charged or discharged with the power greater than the power in the normal working mode, thereby quickly satisfying the SOC calibration condition.

It should be understood that the discharging or charging power in the normal working mode is a discharging or charging power used when the energy storage system performs power allocation based on SOCs of the plurality of battery clusters.

If the controller controls the first battery cluster to be charged, the first battery cluster is charged with a maximum charging power of the energy storage system, where the maximum charging power is greater than the charging power in the normal working mode and is a maximum power calculated by a battery management system BMS of the energy storage system; or if the controller controls the first battery cluster to be discharged, the first battery cluster is discharged with a maximum discharging power of the energy storage system, where the maximum discharging power is greater than the discharging power in the normal working mode and is a maximum power calculated by a battery management system BMS of the energy storage system.

It should be understood that the controller may receive an accumulated running time Tr of the first battery cluster starting from a previous SOC calibration time point and an accumulated non-running time Td of the first battery cluster starting from the previous SOC calibration time point, where Tr and Td are sent by the BMS of the energy storage system; and determine, based on Tr and Td, whether the first battery cluster needs to be calibrated.

Specifically, if the accumulated running time Tr is greater than or equal to a time Ts, it is determined that the first battery cluster is an battery cluster that needs to be calibrated; or if the accumulated non-running time Td is greater than or equal to a time Tp, it is determined that the battery cluster is an battery cluster that needs to be calibrated.

When a plurality of battery clusters need to be calibrated, the controller determines, based on a priority sequence, that the first battery cluster needs to be calibrated. The priority sequence is determined based on a detection sequence. For example, if a battery cluster that needs SOC calibration is detected earlier, a priority corresponding to the battery cluster is higher.

Optionally, when the first battery cluster satisfies the SOC calibration condition, the controller indicates the BMS of the energy storage system to perform SOC calibration on the first battery cluster.

Optionally, the controller receives a notification that is sent by the BMS and that indicates that the SOC calibration performed on the first battery cluster is completed; and controls the first battery cluster to be charged or discharged or to be in a standby state in the normal working mode of the energy storage system.

According to the foregoing technical solution, the first battery cluster can be individually controlled to be charged or discharged or to be in a standby state in this application, so that the first battery cluster satisfies the SOC calibration condition. In this way, charging, discharging, or standby-state control needs to be performed on only one battery cluster that needs to be calibrated in the energy storage system, independent decoupling management is implemented on the battery cluster, running of the energy storage system does not need to exist, and normal running of the energy storage system is not affected. This enables the battery cluster to quickly satisfy the SOC calibration condition, and implements online SOC calibration of the energy storage system. In addition, according to the technical solution of this application, online SOC calibration may be performed in turn on all battery clusters that need to be calibrated in the energy storage system, so that overall SOC accuracy of the energy storage system can be improved.

FIG. 7A to FIG. 7C are a schematic flowchart of a method for controlling an energy storage system according to an embodiment of this application, and further provides detailed descriptions of the control method shown in FIG. 6. The method may include step S701 to step S714. In the following descriptions, the architecture shown in FIG. 2 is used as an example for description.

S701: A BMS monitors a running status of each battery cluster, and records a previous SOC calibration time point Ti, an accumulated running time Tr, and an accumulated non-running time Td of each battery cluster.

It should be understood that the accumulated running time is an accumulated running time of the battery cluster starting from previous SOC calibration, and the accumulated non-running time is an accumulated non-running time of the battery cluster starting from the previous SOC calibration. Non-running means that the battery cluster is in an off state.

S702: The BMS determines whether the accumulated running time Tr is greater than or equal to a preset time Ts.

If Tr is less than the preset time Ts, step S703 is performed; or if Tr is greater than or equal to the preset time Ts, step S704 is performed.

It should be understood that if the accumulated running time Tr is greater than or equal to the time Ts, it indicates that the battery cluster has satisfied a preset calibration condition needed for accumulated running, and the battery cluster needs to be calibrated. The preset calibration condition needed for accumulated running is that the accumulated running time of the battery cluster is greater than the preset Ts.

S703: The BMS determines whether the accumulated non-running time Td is greater than or equal to a preset time Tp.

If Td is less than the preset time Tp, step S701 is performed; or if Td is greater than or equal to the preset time Tp, step S704 is performed.

It should be understood that if the accumulated non-running time Td is greater than or equal to the time Tp, it indicates that the battery cluster has satisfied a preset calibration condition needed for accumulated running, and the battery cluster needs to be calibrated. The preset calibration condition needed for accumulated running is that the accumulated non-running time of the battery cluster is greater than the preset Tp.

S704: If the BMS determines that a plurality of battery clusters need to be calibrated, an EMS performs priority sorting on the clusters.

It should be understood that a standard for the BMS to determine that a battery cluster needs to be calibrated is $Tr \geq Ts$ or $Td \geq Tp$.

It should also be understood that if the BMS determines that a plurality of battery clusters need to be calibrated, the EMS performs, based on a time sequence of detecting that the battery clusters need to be calibrated, priority sorting on the battery clusters that need to be calibrated. If a battery cluster that needs to be calibrated is detected earlier, a priority of the battery cluster is higher.

Optionally, step S704 may be performed by an SACU.

S705: The BMS determines whether a SOC of a battery cluster that needs to be calibrated is greater than a first threshold.

If the SOC of the battery cluster that needs to be calibrated is less than or equal to the first threshold, step S706 is performed; or if the SOC of the battery cluster that needs to be calibrated is greater than the first threshold, step S711 is performed.

It should be understood that, when the BMS determines that the SOC of the battery cluster that needs to be calibrated is greater than the first threshold, it indicates that a current status of the battery cluster more easily reaches a fully charged state than a fully discharged state. Therefore, a subsequent operation is to enable the battery cluster to reach the fully charged state as soon as possible, to satisfy a SOC calibration condition. When the BMS determines that the SOC of the battery cluster that needs to be calibrated is not greater than the first threshold, it indicates that a current status of the battery cluster more easily reaches a fully discharged state than a fully charged state. Therefore, a subsequent operation is to enable the battery cluster to reach the fully discharged state as soon as possible, to satisfy a SOC calibration condition.

It should be understood that in this embodiment, a determining standard used for determining whether the battery cluster satisfies the SOC calibration condition is determining whether the SOC of the battery cluster is in a fully charged/fully discharged state.

Optionally, the first threshold may be 50%.

Optionally, a determining basis used for determining whether the battery cluster satisfies the SOC calibration condition may be alternatively determining whether a voltage of the battery cluster is in a fully charged/fully discharged state.

S706: The EMS controller monitors whether the energy storage system is currently in a charging or discharging state.

It should be understood that the EMS controller monitors whether the energy storage system is currently in a charging or discharging state, so that the EMS can determine, in step S707, whether the energy storage system is in a discharging state, and adjust a status of the battery cluster based on whether the energy storage system is in the discharging state. The status of the battery cluster is participating in discharging or being in a standby state.

Optionally, the EMS may determine that the energy storage system is currently in a charging or discharging state, by determining whether a received power instruction P* obtained through upper-layer scheduling or local control is a positive value. When P* is a positive value, it indicates that the system is in a discharging state. When P* is a negative value, it indicates that the system is in a charging state.

Optionally, step S706 may be alternatively performed by the SACU.

S707: The EMS determines whether the energy storage system is in a discharging state.

If the energy storage system is not in a discharging state, step S708 is performed; or if the energy storage system is in a discharging state, step S709 is performed.

It should be understood that the EMS controller monitors whether the energy storage system is currently in a discharging state, to determine a subsequent operation on the battery cluster that needs to be calibrated. In other words, the battery cluster can reach a fully discharged state as soon as possible by performing different operations, thereby satisfying the SOC calibration condition of the battery cluster.

Optionally, step S707 may be alternatively performed by the SACU.

S708: The EMS controls the battery cluster that needs to be calibrated to be in a standby state, and controls the battery cluster not to participate in energy storage scheduling control.

It should be understood that, when the BMS determines that the SOC of the battery cluster that needs to be calibrated is not greater than the first threshold, a current status of the battery cluster that needs to be calibrated more easily reaches a fully discharged state than a fully charged state. In this case, the battery cluster that needs to be calibrated needs to reach the fully discharged state through discharging. Therefore, when the EMS determines that the energy storage system is not in the discharging state, the battery cluster that needs to be calibrated needs to be in a standby state, and does not participate in energy storage scheduling control. This avoids increasing the SOC of the battery cluster that needs to be calibrated, which is conducive to reaching the fully discharged state.

Optionally, a direct current/direct current converter connected to the battery cluster that needs to be calibrated may be enabled to be in a standby state, so that the battery cluster that needs to be calibrated is enabled to be in a standby state.

Optionally, if a calibration speed is not considered, the battery cluster that needs to be calibrated can still be charged/discharged based on a same power allocation mode of another battery cluster until the battery cluster satisfies the SOC calibration condition.

Optionally, step S708 may be alternatively performed by the SACU.

S709: The EMS controls the battery cluster that needs to be calibrated to participate in discharging within a constraint range of the BMS until the battery cluster satisfies the SOC calibration condition.

It should be understood that, when the BMS determines that the SOC of the battery cluster that needs to be calibrated is not greater than the first threshold, a current status of the battery cluster that needs to be calibrated more easily reaches a fully discharged state than a fully charged state. In this case, the battery cluster that needs to be calibrated needs to reach the fully discharged state through discharging. Therefore, when the EMS determines that the energy storage system is in a discharging state, the battery cluster that needs to be calibrated needs to participate in discharging. In addition, the battery cluster that needs to be calibrated is controlled to participate in discharging within the constraint range of the BMS. In other words, the battery cluster is discharged at a maximum discharging rate (in a calibration mode) allowed by the BMS. This is conducive to making the battery cluster that needs to be calibrated reach the fully discharged state as soon as possible, thereby satisfying the SOC calibration condition of the battery cluster.

It should also be understood that the calibration mode means that the EMS controls a charging power $P=P1_{max}$ of the direct current/direct current converter connected to the battery cluster that needs to be calibrated, until the battery cluster that needs to be calibrated satisfies the SOC calibration condition, where $P1_{max}$ is a maximum charging power that is provided by the BMS and that can run under constraint of a current limiting table or a power limiting table of the battery cluster that needs to be calibrated.

Optionally, if a calibration speed is not considered, the battery cluster that needs to be calibrated can still be charged/discharged based on a same power allocation mode (normal mode) of another battery cluster until the battery cluster satisfies the SOC calibration condition.

It should be understood that in the normal mode, a power allocation mechanism for charging or discharging is specifically as follows: A power $P*-P1_{max}$ left after power allocation is performed on the battery cluster that needs to be calibrated is allocated by other m-1 direct current/direct current converters based on a normal charging or discharging mode.

Specifically, during charging, a small power is allocated to a battery cluster with a large SOC, and a large power is allocated to a battery cluster with a small SOC, to achieve an equalization control effect of simultaneous full charging. For example, if a total power is P*, and the battery cluster that needs to be calibrated is a 1st battery cluster, a charging power of the 1st battery cluster is $P1_{max}$, and in other battery clusters (that is, a 2nd battery cluster to an mth battery cluster), a charging power of an ith battery cluster is $(P*-P1_{max}) \times (1-SOCi)/\sum_{j=2}^{m}(1-SOCj)$, where SOCi is a SOC of the ith battery cluster, and 2≤i≤m. For example, when there are three battery clusters, it is assumed that a battery cluster 1 is the battery cluster that needs to be calibrated, and a ratio between SOCs of a battery cluster 2 and a battery cluster 3 is 4:6. For power allocation during charging, a power allocated to the battery cluster 2 is (P*-P1$_{max}$)×0.6, and a power allocated to the battery cluster 3 is (P*-P1$_{max}$)×0.4. During discharging, a large power is allocated to a battery cluster with a large SOC, and a small power is allocated to a battery cluster with a small SOC, to achieve an equalization control effect of simultaneous full discharging. For example, if a total power is P*, and the battery cluster that needs to be calibrated is a 1st battery cluster, a discharging power of the 1st battery cluster is $P_{1max}$, and in battery clusters (that is, a 2nd battery cluster to an mth battery cluster) other than the battery cluster that needs to be calibrated, a discharging power of an ith battery cluster is $(P*-P1_{max}) \times SOCi/\sum_{j=2}^{m}SOCj$, where SOCi is a SOC of the ith battery cluster, and 2≤i≤m. For example, when there are three battery clusters, it is assumed that a battery cluster 1 is the battery cluster that needs to be calibrated, and a ratio between SOCs of a battery cluster 2 and a battery cluster 3 is 4:6. For power allocation during discharging, a power allocated to the battery cluster 2 is $(P^*-P1_{max})\times0.4$, and a power allocated to the battery cluster 3 is $(P^*-P1_{max})\times0.6$.

It should also be understood that, for n PCSs, the P* power may be evenly allocated to each PCS, that is, a power allocated to each PCS is P*/n.

Optionally, step S709 may be alternatively performed by the SACU.

S710: After completing SOC calibration, the BMS notifies the EMS, so that the calibrated battery cluster participates in normal charging or discharging or standby running.

It should be understood that, before the battery cluster that needs to be calibrated completes calibration, to enable the battery cluster to satisfy the SOC calibration condition as soon as possible, the battery cluster needs to be controlled to be charged/discharged in the calibration mode. To be specific, the battery cluster is charged/discharged by using a maximum running power/current under constraint of the BMS, and does not run in the normal mode (that is, a running mode in which power allocation is performed based on SOCs). After the battery cluster completes the SOC calibration, normal charging or discharging or standby running needs to be restored, that is, the battery cluster runs in the power allocation mode based on the SOCs.

Optionally, in step S710, after completing SOC calibration, the BMS may alternatively notify the SACU, so that the calibrated battery cluster participates in normal charging or discharging or standby running.

S711: The EMS controller monitors whether the energy storage system is currently in a charging or discharging state.

It should be understood that the EMS controller monitors whether the energy storage system is currently in a charging or discharging state, so that the EMS can determine, in step S712, whether the energy storage system is in a charging state, and adjust a status of the battery cluster based on whether the energy storage system is in the charging state. The status of the battery cluster is participating in charging or being in a standby state.

Optionally, the EMS may determine that the energy storage system is currently in a charging or discharging state, by determining whether a received power instruction P* obtained through upper-layer scheduling, for example, a remote terminal unit (RTU), or obtained through local control, for example, a supervisory control and data acquisition (SCADA) system, is a negative value. When P* is a positive value, it indicates that the system is in a discharging state. When P* is a negative value, it indicates that the system is in a charging state.

Optionally, step S711 may be alternatively performed by the SACU.

S712: The EMS determines whether the energy storage system is in a charging state.

If the energy storage system is not in a charging state, step S713 is performed; or if the energy storage system is in a charging state, step S714 is performed.

It should be understood that the EMS controller monitors whether the energy storage system is currently in a charging state, to determine a subsequent operation on the battery cluster that needs to be calibrated. In other words, the battery cluster can reach a fully charged state as soon as possible by performing different operations, thereby satisfying the SOC calibration condition of the battery cluster.

Optionally, step S712 may be alternatively performed by the SACU.

S713: The EMS controls the battery cluster that needs to be calibrated to be in a standby state, and controls the battery cluster not to participate in energy storage scheduling control.

It should be understood that, when the BMS determines that the SOC of the battery cluster that needs to be calibrated is greater than the first threshold, a current status of the battery cluster that needs to be calibrated more easily reaches a fully charged state than a fully discharged state. In this case, the battery cluster that needs to be calibrated needs to reach the fully charged state through charging. Therefore, when the EMS determines that the energy storage system is not in the charging state, the battery cluster that needs to be calibrated needs to be in a standby state, and does not participate in energy storage scheduling control. This avoids decreasing the SOC of the battery cluster that needs to be calibrated, which is not conducive to reaching the fully charged state.

Optionally, a direct current/direct current converter connected to the battery cluster that needs to be calibrated may be enabled to be in a standby state, so that the battery cluster that needs to be calibrated is enabled to be in a standby state.

Optionally, if a calibration speed is not considered, the battery cluster that needs to be calibrated can still be charged/discharged based on a same power allocation mode of another battery cluster until the battery cluster satisfies the SOC calibration condition.

Optionally, step S713 may be alternatively performed by the SACU.

S714: The EMS controls the battery cluster that needs to be calibrated to participate in charging within a constraint range of the BMS until the battery cluster satisfies the SOC calibration condition.

It should be understood that, when the BMS determines that the SOC of the battery cluster that needs to be calibrated is greater than the first threshold, a current status of the battery cluster that needs to be calibrated more easily reaches a fully charged state than a fully discharged state. In this case, the battery cluster that needs to be calibrated needs to reach the fully charged state through charging. Therefore, when the EMS determines that the energy storage system is in a charging state, the battery cluster that needs to be calibrated needs to participate in charging. In addition, the battery cluster that needs to be calibrated is controlled to participate in charging within the constraint range of the BMS. In other words, the battery cluster is charged at a maximum charging rate (in a calibration mode) allowed by the BMS. This is conducive to making the battery cluster that needs to be calibrated reach the fully charged state as soon as possible, thereby satisfying the SOC calibration condition of the battery cluster.

It should also be understood that the calibration mode means that the EMS controls a discharging power $P=P1_{max}$ of the direct current/direct current converter connected to the battery cluster that needs to be calibrated, until the battery cluster that needs to be calibrated satisfies the SOC calibration condition, where $P1_{max}$ is a maximum discharging power that is provided by the BMS and that can run under constraint of a current limiting table or a power limiting table of the battery cluster that needs to be calibrated.

Optionally, if a calibration speed is not considered, the battery cluster that needs to be calibrated can still be charged/discharged based on a same power allocation mode (normal mode) of another battery cluster until the battery cluster satisfies the SOC calibration condition. The normal mode is described in S709, and details are not described herein again.

It should be understood that, for n PCSs, the P* power may be evenly allocated to each PCS, that is, a power allocated to each PCS is P*/n.

Optionally, step S714 may be alternatively performed by the SACU.

It should be understood that, whether the voltage or the SOC of the battery cluster reaches the fully charged/fully discharged state is used as a standard for determining whether the battery cluster satisfies the SOC calibration condition, or another general standard that can be readily figured out by a person skilled in the art is used. These standards all fall within the protection scope of this application.

According to the foregoing control policy, independent decoupling management can be implemented on each battery cluster, and impact on SOC calibration of the energy storage system is minimized. In addition, online SOC calibration is performed on the battery clusters in turn according to the control policy of the embodiment, to ultimately improve overall SOC accuracy of the energy storage system. Finally, according to the foregoing policy, an independent calibration running mode for the battery clusters can be provided, and quick SOC calibration performed on the battery clusters can be implemented.

For the architecture shown in FIG. 3, the online SOC calibration control policy in this application is similar to the online SOC calibration control policy shown in FIG. 2. A difference from the online SOC calibration control policy shown in FIG. 2 lies in that, in the architecture shown in FIG. 3, power allocation in steps S708 and S709 and steps S713 and S714 is PCS power allocation, and the direct current/direct current converters can work in the voltage source mode.

For the architecture shown in FIG. 4, the online SOC calibration control policy in this application is similar to the online SOC calibration control policy shown in FIG. 2. A difference from the online SOC calibration control policy shown in FIG. 2 lies in that, in the architecture shown in FIG. 4, power allocation in steps S708 and S709 and steps S713 and S714 is PCS power allocation, and the charging/discharging power of each battery cluster can be controlled by controlling the power of each PCS.

For the architecture shown in FIG. 5, the online SOC calibration control policy in this application is similar to the online SOC calibration control policy shown in FIG. 2. A difference from the online SOC calibration control policy shown in FIG. 2 lies in that, in the architecture shown in FIG. 5, the PCS in step S709 and step S714 can be directly under P* control.

It should be understood that the foregoing content describes in detail a method for controlling an energy storage system provided in this application. The method is performed by a controller in the energy storage system. For example, the controller may be an EMS or an SACU. This is not limited in this application.

It should be understood that the components in the energy storage system in embodiments of this application may be configured to perform the methods for controlling the energy storage system that are shown in FIG. 6 and FIG. 7A to FIG. 7C. For corresponding beneficial effects and functions, refer to the foregoing detailed descriptions of the methods for controlling the energy storage system. Details are not described herein again.

Terms such as "component", "module", and "system" used in this specification are used to indicate computer-related entities, hardware, firmware, combinations of hardware and software, software, or software being executed. For example, a component may be but is not limited to a process that runs on a processor, a processor, an object, an executable file, a thread of execution, a program, and/or a computer. As shown in figures, both a computing device and an application that runs on a computing device may be components. One or more components may reside within a process and/or a thread of execution, and a component may be located on one computer and/or distributed between two or more computers. In addition, these components may be executed from various computer-readable media that store various data structures. The components may communicate with each other by using a local and/or remote process and based on, for example, a signal having one or more data packets (for example, data from one component interacting with another component in a local system, a distributed system, and/or across a network such as the Internet interacting with other systems by using the signal).

A person of ordinary skill in the art can be aware that, in combination with the examples described in embodiments disclosed in this specification, units and algorithm steps can be implemented by electronic hardware or a combination of computer software and electronic hardware. Whether the functions are performed by hardware or software depends on particular applications and design constraints of the technical solutions. A person skilled in the art may use a different method to implement the described functions for each particular application, but it should not be considered that the implementation goes beyond the scope of this application.

It can be clearly understood by a person skilled in the art that, for the purpose of convenient and brief description, for detailed working processes of the systems, apparatuses, and units, refer to corresponding processes in the method embodiments. Details are not described herein again.

In the several embodiments provided in this application, it should be understood that the disclosed systems, apparatuses, and methods may be implemented in other manners. For example, the described apparatus embodiments are merely examples. For example, the unit division is merely logical function division and may be other division in actual implementation. For example, a plurality of units or components may be combined or may be integrated into another system, or some features may be ignored or not be performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units, may be located in one position, or may be distributed on a plurality of network units. Some or all of the units may be selected depending on an actual requirement to achieve the objectives of the solutions of embodiments.

In addition, functional units in embodiments of this application may be integrated into one processing unit, each of the units may exist alone physically, or at least two units may be integrated into one unit.

When the functions are implemented in a form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The computer software product is stored in a storage medium, and includes several instructions for instructing a computer device (which may be a personal computer, a server, a network device, or the like) to perform all the methods described in embodiments of this application. The foregoing storage medium includes: any medium that can store program code, such as a USB flash drive, a removable hard disk, a read-only memory (ROM), a random access memory (RAM), a magnetic disk, or an optical disc.

It should also be noted that terms such as first, second, and third used in embodiments of this application are for ease of description, and should not be construed as any limitation on the application scope of embodiments of this application.

The foregoing descriptions are merely specific implementations of this application, but are not intended to limit the protection scope of this application. Therefore, the protection scope of this application shall be subject to the protection scope of the claims.

**Claims**

1. A method for controlling an energy storage system, wherein the energy storage system comprises a plurality of battery clusters, a plurality of direct current/direct current converters, and a controller, the plurality of battery clusters are in a one-to-one correspondence with the plurality of direct current/direct current converters, so that the controller individually controls each of the plurality of battery clusters, the method is performed by the controller, and the method comprises:

   determining that a first battery cluster in the plurality of battery clusters needs to be calibrated (S610); and
   controlling, based on a state of charge SOC of the first battery cluster and a current charging or discharging state of the energy storage system, the first battery cluster to be charged or discharged or to be in a standby state, so that the first battery cluster satisfies a SOC calibration condition, wherein the SOC calibration condition is a fully charged or fully discharged state and **characterized in that** the controlling comprises the steps of:

   if the SOC of the first battery cluster is greater than or equal to a first threshold, when the energy storage system is in a charging state, controlling the first battery cluster to be charged with a charging power greater than a charging power in a normal working mode of the energy storage system, wherein the charging power in the normal working mode is a charging power used when the energy storage system performs power allocation based on SOCs of the plurality of battery clusters, and when the energy storage system is in a discharging state, controlling the first battery cluster to be in a standby state until the energy storage system is in a charging state; and

if the SOC of the first battery cluster is less than the first threshold, when the energy storage system is in a discharging state, controlling the first battery cluster to be discharged with a discharging power greater than a discharging power in a normal working mode of the energy storage system, wherein the discharging power in the normal working mode is a discharging power used when the energy storage system performs power allocation based on SOCs of the plurality of battery clusters, and when the energy storage system is in a charging state, controlling the first battery cluster to be in a standby state until the energy storage system is in a discharging state.

2. The method according to claim 1, wherein the controlling the first battery cluster to be charged comprises:

controlling the first battery cluster to be charged with a maximum charging power of the energy storage system, wherein the maximum charging power is greater than the charging power in the normal working mode and is a maximum power calculated by a battery management system BMS; or
the controlling the first battery cluster to be discharged comprises:
controlling the first battery cluster to be discharged with a maximum discharging power of the energy storage system, wherein the maximum discharging power is greater than the discharging power in the normal working mode and is a maximum power calculated by a battery management system BMS.

3. The method according to any one of claim 1 or claim 2, wherein the determining that a first battery cluster in the plurality of battery clusters needs to be calibrated comprises:

receiving an accumulated running time Tr of the first battery cluster starting from a previous SOC calibration time point and an accumulated non-running time Td of the first battery cluster starting from the previous SOC calibration time point, wherein Tr and Td are sent by the BMS of the energy storage system; and
determining, based on Tr and Td, that the first battery cluster needs to be calibrated.

4. The method according to claim 3, wherein the determining, based on Tr and Td, that the first battery cluster needs to be calibrated comprises:

If the accumulated running time Tr is greater than or equal to a time Ts, determining that the first battery cluster is an battery cluster that needs to be calibrated; or
if the accumulated non-running time Td is greater than or equal to a time Tp, determining that the first battery cluster is an battery cluster that needs to be calibrated.

5. The method according to any one of claims 1 to 4, wherein the method further comprises:

receiving a notification that is sent by the BMS and that indicates that the SOC calibration performed on the first battery cluster is completed; and
controlling the first battery cluster to be charged or discharged or to be in a standby state in the normal working mode of the energy storage system, wherein the normal working mode is a mode in which the energy storage system performs power allocation based on the SOCs of the plurality of battery clusters.

6. An energy storage system, wherein the energy storage system comprises a plurality of battery clusters, a plurality of direct current/direct current converters, a controller, and a battery management system BMS, and the plurality of battery clusters are in a one-to-one correspondence with the plurality of direct current/direct current converters, so that the controller individually controls each of the plurality of battery clusters;

the BMS is configured to: obtain states of charge SOCs of the plurality of battery clusters, and send the SOCs of the plurality of battery clusters to the controller; and
the controller is configured to: determine that a first battery cluster in the plurality of battery clusters needs to be calibrated, and control, based on a SOC of the first battery cluster and a current charging or discharging state of the energy storage system, the first battery cluster to be charged or discharged or to be in a standby state, so that the first battery cluster satisfies a SOC calibration condition, wherein the SOC calibration condition is a fully charged or fully discharged state and **characterized in that** the controller is further configured to:

if the SOC of the first battery cluster is greater than or equal to a first threshold, when the energy storage system is in a charging state, control the first battery cluster to be charged with a charging power greater than a charging power in a normal working mode of the energy storage system, wherein the charging power in the normal working mode is a charging power used when the energy storage system performs power allocation based on SOCs of the plurality of battery clusters, and when the energy storage system is in a discharging state, control the first battery cluster to be in a standby state until the energy storage system is in a charging state; and

if the SOC of the first battery cluster is less than the first threshold, when the energy storage system is in a discharging state, control the first battery cluster to be discharged with a discharging power greater than a discharging power in a normal working mode of the energy storage system, wherein the discharging power in the normal working mode is a discharging power used when the energy storage system performs power allocation based on SOCs of the plurality of battery clusters, and when the energy storage system is in a charging state, control the first battery cluster to be in a standby state until the energy storage system is in a discharging state.

7. The energy storage system according to claim 6, wherein the controller is configured to:

control the first battery cluster to be charged with a maximum charging power of the energy storage system, wherein the maximum charging power is greater than the charging power in the normal working mode and is a maximum power calculated by the BMS; or
control the first battery cluster to be discharged with a maximum discharging power of the energy storage system, wherein the maximum discharging power is greater than the discharging power in the normal working mode and is a maximum power calculated by the BMS.

8. The energy storage system according to any one of claim 6 or claim 7, wherein the BMS is further configured to send, to the controller, an accumulated running time Tr of the first battery cluster starting from a previous SOC calibration time point and an accumulated non-running time Td of the first battery cluster starting from the previous SOC calibration time point; and
the controller is configured to determine, based on Tr and Td, that the first battery cluster needs to be calibrated.

9. The energy storage system according to claim 8, wherein the controller is configured to:

if the accumulated running time Tr is greater than or equal to a time Ts, determine that the first battery cluster is an battery cluster that needs to be calibrated; or
if the accumulated non-running time Td is greater than or equal to a time Tp, determining that the first battery cluster is an battery cluster that needs to be calibrated.

10. The energy storage system according to claim 9, wherein the controller is configured to: when a plurality of battery clusters are battery clusters that need to be calibrated, determine, based on a priority sequence, that the first battery cluster needs to be calibrated.

11. The energy storage system according to any one of claims 6 to 10, wherein the BMS is further configured to: send, to the controller, a notification that indicates that the SOC calibration performed on the first battery cluster is completed; and
the controller is further configured to: receive the notification that is sent by the BMS and that indicates that the SOC calibration performed on the first battery cluster is completed, and control the first battery cluster to be charged or discharged or to be in a standby state in the normal working mode of the energy storage system, wherein the normal working mode is a mode in which the energy storage system performs power allocation based on the SOCs of the plurality of battery clusters.

**Patentansprüche**

1. Verfahren zum Steuern eines Energiespeicherungssystems, wobei das Energiespeicherungssystem eine Vielzahl von Batterieclustern, eine Vielzahl von Gleichstrom/Gleichstrom-Wandlern und eine Steuerung umfasst, wobei die Vielzahl von Batterieclustern in einer Eins-Zu-Eins-Beziehung mit der Vielzahl von Gleichstrom/Gleichstrom-Wandlern steht, sodass die Steuerung jeden der Vielzahl von Batterieclustern einzeln steuert, wobei das Verfahren von der Steuerung durchgeführt wird und das Verfahren umfasst:

Bestimmen, dass ein erster Batteriecluster aus der Vielzahl von Batterieclustern kalibriert (S610) werden muss; und

Steuern basierend auf einem Ladezustand SOC des ersten Batterieclusters und einem aktuellen Lade- oder Entladezustand des Energiespeicherungssystems, des ersten Batterieclusters, um geladen oder entladen zu werden oder um sich in einem Standby-Zustand zu befinden, sodass der erste Batteriecluster eine SOC-Kalibrierungsbedingung erfüllt, wobei die SOC-Kalibrierungsbedingung ein vollständig geladener oder vollständig entladener Zustand ist und **dadurch gekennzeichnet ist,**
**dass** das Steuern die folgenden Schritte umfasst:

falls der SOC des ersten Batterieclusters größer als oder gleich ein ersten Schwellenwert ist, wenn sich das Energiespeicherungssystem in einem Ladezustand befindet, Steuern des ersten Batterieclusters, um mit einer Ladeleistung, die größer als eine Ladeleistung in einem normalen Betriebsmodus des Energiespeicherungssystems ist, geladen zu werden, wobei die Ladeleistung in dem normalen Betriebsmodus eine Ladeleistung ist, die verwendet wird, wenn das Energiespeicherungssystem eine Leistungszuweisung basierend auf SOCs der Vielzahl von Batterieclustern durchführt, und wenn sich das Energiespeicherungssystem in einem Entladezustand befindet, Steuern des ersten Batterieclusters, sodass er sich in einem Standby-Zustand befindet, bis sich das Energiespeicherungssystem in einem Ladezustand befindet; und falls der SOC des ersten Batterieclusters unter dem ersten Schwellenwert liegt, wenn sich das Energiespeicherungssystem in einem Entladezustand befindet, Steuern des ersten Batterieclusters, um mit einer Entladeleistung, die größer als eine Entladeleistung in einem normalen Betriebsmodus des Energiespeicherungssystems ist, entladen zu werden, wobei die Entladeleistung in dem normalen Betriebsmodus eine Entladeleistung ist, die verwendet wird, wenn das Energiespeicherungssystem die Leistungszuweisung basierend auf den SOCs der Vielzahl von Batterieclustern durchführt, und wenn sich das Energiespeicherungssystem in einem Ladezustand befindet, Steuern des ersten Batterieclusters, um sich in einem Standby-Zustand zu befinden, bis sich das Energiespeicherungssystem in einem Entladezustand befindet.

2. Verfahren nach Anspruch 1, wobei das Steuern des ersten Batterieclusters, um geladen zu werden, umfasst:

Steuern des ersten Batterieclusters, um mit einer maximalen Ladeleistung des Energiespeicherungssystems geladen zu werden, wobei die maximale Ladeleistung größer als die Ladeleistung in dem normalen Betriebsmodus ist und eine von einem Batterieverwaltungssystem BMS berechnete maximale Leistung ist; oder das Steuern des ersten Batterieclusters, um entladen zu werden, umfasst:
Steuern des ersten Batterieclusters, um mit einer maximalen Entladeleistung des Energiespeicherungssystems entladen zu werden, wobei die maximale Entladeleistung größer als die Entladeleistung in dem normalen Betriebsmodus ist und eine maximale Leistung, die von einem Batterieverwaltungssystem BMS berechnet wird, ist.

3. Verfahren nach einem der Ansprüche 1 oder 2, wobei das Bestimmen, dass ein erster Batteriecluster in der Vielzahl von Batterieclustern kalibriert werden muss, umfasst:

Empfangen einer akkumulierten Laufzeit Tr des ersten Batterieclusters ab einem vorherigen SOC-Kalibrierungszeitpunkt und einer akkumulierten Nicht-Laufzeit Td des ersten Batterieclusters ab dem vorherigen SOC-Kalibrierungszeitpunkt, wobei Tr und Td von dem BMS des Energiespeicherungssystems gesendet werden; und Bestimmen basierend auf Tr und Td, dass der erste Batteriecluster kalibriert werden muss.

4. Verfahren nach Anspruch 3, wobei das Bestimmen basierend auf Tr und Td, dass der erste Batteriecluster kalibriert werden muss, umfasst:
Falls die akkumulierte Laufzeit Tr größer als oder gleich einer Zeit Ts ist, Bestimmen, dass der erste Batteriecluster ein Batteriecluster, der kalibriert werden muss, ist; oder falls die akkumulierte Nicht-Laufzeit Td größer als oder gleich einer Zeit Tp ist, Bestimmen, dass der erste Batteriecluster ein Batteriecluster, der kalibriert werden muss, ist.

5. Verfahren nach einem der Ansprüche 1 bis 4, wobei das Verfahren ferner umfasst:

Empfangen einer Benachrichtigung, die von dem BMS gesendet wird und die anzeigt, dass die an dem ersten Batteriecluster durchgeführte SOC-Kalibrierung abgeschlossen ist; und Steuern des ersten Batterieclusters, um in dem normalen Betriebsmodus des Energiespeicherungssystems geladen oder entladen zu werden oder um sich in einem Standby-Zustand zu befinden, wobei der normale Betriebsmodus ein Modus, in dem das Energiespeicherungssystem die Leistungszuweisung basierend auf den SOCs der Vielzahl von Batterieclustern durchführt, ist.

**6.** Energiespeicherungssystem, wobei das Energiespeicherungssystem eine Vielzahl von Batterieclustern, eine Vielzahl von Gleichspannungswandlern, eine Steuerung und ein Batterieverwaltungssystem BMS umfasst und die Vielzahl von Batterieclustern in einer Eins-Zu-Eins-Beziehung mit der Vielzahl von Gleichspannungswandlern steht, sodass die Steuerung jeden der Vielzahl von Batterieclustern einzeln steuert;

das BMS konfiguriert ist zum: Erhalten von Ladezuständen SOCs der Vielzahl von Batterieclustern und Senden der SOCs der Vielzahl von Batterieclustern an die Steuerung; und

die Steuerung konfiguriert ist zum: Bestimmen, dass ein erster Batteriecluster aus der Vielzahl von Batterieclustern kalibriert werden muss, und Steuern basierend auf einem SOC des ersten Batterieclusters und dem aktuellen Lade- oder Entladezustand des Energiespeicherungssystems, des ersten Batterieclusters, um geladen oder entladen zu werden oder sich in einem Standby-Zustand zu befinden, sodass der erste Batteriecluster eine SOC-Kalibrierungsbedingung erfüllt, wobei die SOC-Kalibrierungsbedingung ein vollständig geladener oder vollständig entladener Zustand ist und **dadurch gekennzeichnet, dass** die Steuerung ferner konfiguriert ist zum: falls der SOC des ersten Batterieclusters größer als ein erster Schwellenwert ist, wenn sich das Energiespeicherungssystem in einem Ladezustand befindet, Steuern des ersten Batterieclusters, um mit einer Ladeleistung, die größer als eine Ladeleistung in einem normalen Betriebsmodus des Energiespeicherungssystems ist, geladen zu werden, wobei die Ladeleistung in dem normalen Betriebsmodus eine Ladeleistung ist, die verwendet wird, wenn das Energiespeicherungssystem eine Leistungszuweisung basierend auf SOCs der Vielzahl von Batterieclustern durchführt, und wenn sich das Energiespeicherungssystem in einem Entladezustand befindet, Steuern des ersten Batterieclusters, um sich in einem Standby-Zustand zu befinden, bis sich das Energiespeicherungssystem in einem Ladezustand befindet; und

falls der SOC des ersten Batterieclusters unter dem ersten Schwellenwert liegt, wenn sich das Energiespeicherungssystem in einem Entladezustand befindet, Steuern des ersten Batteriecluster, um mit einer Entladeleistung, die größer als eine Entladeleistung in einem normalen Betriebsmodus des Energiespeicherungssystems ist, entladen zu werden, wobei die Entladeleistung in dem normalen Betriebsmodus eine Entladeleistung ist, die verwendet wird, wenn das Energiespeicherungssystem die Leistungszuweisung basierend auf den SOCs der Vielzahl von Batterieclustern durchführt, und wenn sich das Energiespeicherungssystems in einem Ladezustand befindet, Steuern des ersten Batterieclusters, um sich in einem Standby-Zustand zu befinden, bis sich das Energiespeicherungssystem in einem Entladezustand befindet.

**7.** Energiespeicherungssystem nach Anspruch 6, wobei die Steuerung konfiguriert ist zum:
Steuern des ersten Batterieclusters, um mit einer maximalen Ladeleistung des Energiespeicherungssystems geladen zu werden, wobei die maximale Ladeleistung größer als die Ladeleistung in dem normalen Betriebsmodus ist und eine von dem BMS berechnete maximale Leistung ist; oder Steuern des ersten Batterieclusters, um mit einer maximalen Entladeleistung des Energiespeicherungssystems entladen zu werden, wobei die maximale Entladeleistung größer als die Entladeleistung in dem normalen Betriebsmodus ist und eine von dem BMS berechnete maximale Leistung ist.

**8.** Energiespeicherungssystem nach einem von Anspruch 6 oder 7, wobei das BMS ferner konfiguriert ist, um eine akkumulierte Laufzeit Tr des ersten Batterieclusters ab einem vorherigen SOC-Kalibrierungszeitpunkt und eine akkumulierte Nicht-Laufzeit Td des ersten Batterieclusters ab dem vorherigen SOC-Kalibrierungszeitpunkt an die Steuerung zu senden; und

die Steuerung konfiguriert ist, um basierend auf der Tr und der Td zu bestimmen, dass der erste Batteriecluster kalibriert werden muss.

**9.** Energiespeicherungssystem nach Anspruch 8, wobei die Steuerung konfiguriert ist zum:
falls die akkumulierte Laufzeit Tr größer als oder gleich einer Zeit Ts ist, Bestimmen, dass der erste Batteriecluster ein Batteriecluster, der kalibriert werden muss, ist; oder falls die akkumulierte Nicht-Laufzeit Td größer als oder gleich einer Zeit Tp ist, Bestimmen, dass der erste Batteriecluster ein Batteriecluster, der kalibriert werden muss, ist.

**10.** Energiespeicherungssystem nach Anspruch 9, wobei die Steuerung konfiguriert ist, zum: wenn eine Vielzahl von Batterieclustern Batteriecluster sind, die kalibriert werden müssen, Bestimmen basierend auf einer Prioritätsabfolge, dass der erste Batteriecluster kalibriert werden muss.

**11.** Energiespeicherungssystem nach einem der Ansprüche 6 bis 10, wobei das BMS ferner konfiguriert ist zum: Senden, an die Steuerung, einer Benachrichtigung, die anzeigt, dass die an dem ersten Batteriecluster durchgeführte SOC-Kalibrierung abgeschlossen ist; und

die Steuerung ferner konfiguriert ist zum: Empfangen der von dem BMS gesendeten Benachrichtigung, die anzeigt, dass die an dem ersten Batteriecluster durchgeführte SOC-Kalibrierung abgeschlossen ist, und Steuern des ersten Batclusters, um in dem normalen Betriebsmodus des Energiespeicherungssystems geladen oder entladen zu werden oder um sich in einem Standby-Zustand zu befinden, wobei der normale Betriebsmodus ein Modus, in dem das Energiespeicherungssystem die Leistungszuweisung basierend auf den SOCs der Vielzahl von Batterieclustern durchführt, ist.

**Revendications**

1. Procédé de commande d'un système de stockage d'énergie, dans lequel le système de stockage d'énergie comprend une pluralité de groupes de batteries, une pluralité de convertisseurs courant continu/courant continu, et un dispositif de commande, la pluralité de groupes de batteries sont en correspondance biunivoque avec la pluralité de convertisseurs courant continu/courant continu, de sorte que le dispositif de commande commande individuellement chacun de la pluralité de groupes de batteries, le procédé est effectué par le dispositif de commande, et le procédé comprend :

le fait de déterminer qu'un premier groupe de batteries dans la pluralité de groupes de batteries doit être étalonné (S610) ; et

la commande, sur la base d'un état de charge SOC du premier groupe de batteries et d'un état actuel de charge ou de décharge du système de stockage d'énergie, de la charge ou de la décharge ou de la mise dans un état de veille du premier groupe de batteries, de sorte que le premier groupe de batteries satisfait à une condition d'étalonnage de SOC, dans lequel la condition d'étalonnage de SOC est un état entièrement chargé ou entièrement déchargé, et **caractérisé en ce que** la commande comprend les étapes consistant à :

si le SOC du premier groupe de batteries est supérieur ou égal à un premier seuil, lorsque le système de stockage d'énergie est dans un état de charge, commander la charge du premier groupe de batteries avec une puissance de charge supérieure à une puissance de charge dans un mode de fonctionnement normal du système de stockage d'énergie, dans lequel la puissance de charge dans le mode de fonctionnement normal est une puissance de charge utilisée lorsque le système de stockage d'énergie effectue une attribution de puissance sur la base de SOC de la pluralité de groupes de batteries, et lorsque le système de stockage d'énergie est dans un état de décharge, commander la mise dans un état de veille du premier groupe de batteries jusqu'à ce que le système de stockage d'énergie soit dans un état de charge ; et

si le SOC du premier groupe de batteries est inférieur au premier seuil, lorsque le système de stockage d'énergie est dans un état de décharge, commander la décharge du premier groupe de batteries avec une puissance de décharge supérieure à une puissance de décharge dans un mode de fonctionnement normal du système de stockage d'énergie, dans lequel la puissance de décharge dans le mode de fonctionnement normal est une puissance de décharge utilisée lorsque le système de stockage d'énergie effectue une attribution de puissance sur la base de SOC de la pluralité de groupes de batteries, et lorsque le système de stockage d'énergie est dans un état de charge, commander la mise dans un état de veille du premier groupe de batteries jusqu'à ce que le système de stockage d'énergie soit dans un état de décharge.

2. Procédé selon la revendication 1, dans lequel la commande de la charge du premier groupe de batteries comprend :

la commande de la charge du premier groupe de batteries avec une puissance de charge maximale du système de stockage d'énergie, dans lequel la puissance de charge maximale est supérieure à la puissance de charge dans le mode de fonctionnement normal et est une puissance maximale calculée par un système de gestion de batterie BMS ; ou
la commande de la décharge du premier groupe de batteries comprend :
la commande de la décharge du premier groupe de batteries avec une puissance de décharge maximale du système de stockage d'énergie, dans lequel la puissance de décharge maximale est supérieure à la puissance de décharge dans le mode de fonctionnement normal et est une puissance maximale calculée par un système de gestion de batterie BMS.

3. Procédé selon l'une quelconque de la revendication 1 ou de la revendication 2, dans lequel le fait de déterminer qu'un premier groupe de batteries dans la pluralité de groupes de batteries doit être étalonné comprend :

la réception d'une durée de fonctionnement cumulée Tr du premier groupe de batteries à partir d'un instant d'étalonnage de SOC précédent et d'une durée de non-fonctionnement cumulée Td du premier groupe de batteries à partir de l'instant d'étalonnage de SOC précédent, dans lequel Tr et Td sont envoyées par le BMS du système de stockage d'énergie ; et

le fait de déterminer, sur la base de Tr et Td, que le premier groupe de batteries doit être étalonné.

4.  Procédé selon la revendication 3, dans lequel le fait de déterminer, sur la base de Tr et Td, que le premier groupe de batteries doit être étalonné comprend :

si la durée de fonctionnement cumulée Tr est supérieure ou égale à une durée Ts, le fait de déterminer que le premier groupe de batteries est un groupe de batteries qui doit être étalonné ; ou

si la durée de non-fonctionnement cumulée Td est supérieure ou égale à une durée Tp, le fait de déterminer que le premier groupe de batteries est un groupe de batteries qui doit être étalonné.

5.  Procédé selon l'une quelconque des revendications 1 à 4, dans lequel le procédé comprend en outre :
la réception d'une notification qui est envoyée par le BMS et qui indique que l'étalonnage de SOC effectué sur le premier groupe de batteries est terminé ; et la commande de la charge ou de la décharge ou de la mise dans un état de veille du premier groupe de batteries dans le mode de fonctionnement normal du système de stockage d'énergie, dans lequel le mode de fonctionnement normal est un mode dans lequel le système de stockage d'énergie effectue une attribution de puissance sur la base des SOC de la pluralité de groupes de batteries.

6.  Système de stockage d'énergie, dans lequel le système de stockage d'énergie comprend une pluralité de groupes de batteries, une pluralité de convertisseurs courant continu/courant continu, un dispositif de commande, et un système de gestion de batterie BMS, et la pluralité de groupes de batteries sont en correspondance biunivoque avec la pluralité de convertisseurs courant continu/courant continu, de sorte que le dispositif de commande commande individuellement chacun de la pluralité de groupes de batteries ;

le BMS est configuré pour : obtenir des états de charge SOC de la pluralité de groupes de batteries, et envoyer les SOC de la pluralité de groupes de batteries au dispositif de commande ; et
le dispositif de commande est configuré pour : déterminer qu'un premier groupe de batteries dans la pluralité de groupes de batteries doit être étalonné, et commander, sur la base d'un SOC du premier groupe de batteries et d'un état actuel de charge ou de décharge du système de stockage d'énergie, la charge ou la décharge ou la mise dans un état de veille du premier groupe de batteries, de sorte que le premier groupe de batteries satisfait à une condition d'étalonnage de SOC, dans lequel la condition d'étalonnage de SOC est un état entièrement chargé ou entièrement déchargé, et **caractérisé en ce que** le dispositif de commande est en outre configuré pour : si le SOC du premier groupe de batteries est supérieur ou égal à un premier seuil, lorsque le système de stockage d'énergie est dans un état de charge, commander la charge du premier groupe de batteries avec une puissance de charge supérieure à une puissance de charge dans un mode de fonctionnement normal du système de stockage d'énergie, dans lequel la puissance de charge dans le mode de fonctionnement normal est une puissance de charge utilisée lorsque le système de stockage d'énergie effectue une attribution de puissance sur la base de SOC de la pluralité de groupes de batteries, et lorsque le système de stockage d'énergie est dans un état de décharge, commander la mise dans un état de veille du premier groupe de batteries jusqu'à ce que le système de stockage d'énergie soit dans un état de charge ; et si le SOC du premier groupe de batteries est inférieur au premier seuil, lorsque le système de stockage d'énergie est dans un état de décharge, commander la décharge du premier groupe de batteries avec une puissance de décharge supérieure à une puissance de décharge dans un mode de fonctionnement normal du système de stockage d'énergie, dans lequel la puissance de décharge dans le mode de fonctionnement normal est une puissance de décharge utilisée lorsque le système de stockage d'énergie effectue une attribution de puissance sur la base de SOC de la pluralité de groupes de batteries, et lorsque le système de stockage d'énergie est dans un état de charge, commander la mise dans un état de veille du premier groupe de batteries jusqu'à ce que le système de stockage d'énergie soit dans un état de décharge.

7.  Système de stockage d'énergie selon la revendication 6, dans lequel le dispositif de commande est configuré pour : commander la charge du premier groupe de batteries avec une puissance de charge maximale du système de stockage d'énergie, dans lequel la puissance de charge maximale est supérieure à la puissance de charge dans le mode de fonctionnement normal et est une puissance maximale calculée par le BMS ; ou commander la décharge du premier groupe de batteries avec une puissance de décharge maximale du système de stockage d'énergie, dans lequel la puissance de décharge maximale est supérieure à la puissance de décharge dans le mode de fonctionnement normal et est une puissance maximale calculée par le BMS.

8.  Système de stockage d'énergie selon l'une quelconque de la revendication 6 ou de la revendication 7, dans lequel le BMS est en outre configuré pour envoyer, au dispositif de commande, une durée de fonctionnement cumulée Tr du premier groupe de batteries à partir d'un instant d'étalonnage de SOC précédent et une durée de non-fonctionnement cumulée Td du premier groupe de batteries à partir de l'instant d'étalonnage de SOC précédent ; et

le dispositif de commande est configuré pour déterminer, sur la base de Tr et Td, que le premier groupe de batteries doit être étalonné.

9.  Système de stockage d'énergie selon la revendication 8, dans lequel le dispositif de commande est configuré pour :

si la durée de fonctionnement cumulée Tr est supérieure ou égale à une durée Ts, déterminer que le premier groupe de batteries est un groupe de batteries qui doit être étalonné ; ou

si la durée de non-fonctionnement cumulée Td est supérieure ou égale à une durée Tp, déterminer que le premier groupe de batteries est un groupe de batteries qui doit être étalonné.

10.  Système de stockage d'énergie selon la revendication 9, dans lequel le dispositif de commande est configuré pour : lorsqu'une pluralité de groupes de batteries sont des groupes de batteries qui doivent être étalonnés, déterminer, sur la base d'une séquence de priorités, que le premier groupe de batteries doit être étalonné.

11.  Système de stockage d'énergie selon l'une quelconque des revendications 6 à 10, dans lequel le BMS est en outre configuré pour : envoyer, au dispositif de commande, une notification qui indique que l'étalonnage de SOC effectué sur le premier groupe de batteries est terminé ; et

le dispositif de commande est en outre configuré pour : recevoir la notification qui est envoyée par le BMS et qui indique que l'étalonnage de SOC effectué sur le premier groupe de batteries est terminé, et commander la charge ou la décharge ou la mise dans un état de veille du premier groupe de batteries dans le mode de fonctionnement normal du système de stockage d'énergie, dans lequel le mode de fonctionnement normal est un mode dans lequel le système de stockage d'énergie effectue une attribution de puissance sur la base des SOC de la pluralité de groupes de batteries.

<u>100</u>

FIG. 1

FIG. 2

FIG. 3

FIG. 4

FIG. 5

S610: A controller determines that a first energy storage unit cluster in a plurality of energy storage unit clusters in an energy storage system needs to be calibrated

S620: The controller controls, based on a state of charge SOC of the first energy storage unit cluster and a current charging or discharging state of the energy storage system, the first energy storage unit cluster to be charged or discharged or to be in a standby state, so that the first energy storage unit cluster satisfies a SOC calibration condition

FIG. 6

TO
FIG. 7B

FIG. 7A

CONT.
FROM
FIG. 7A

S704

If a plurality of clusters need to be calibrated, an EMS performs priority sorting on the clusters

S708

The EMS controls the battery cluster that needs to be calibrated to be in a standby state, and controls the battery cluster not to participate in energy storage scheduling control

S705

The BMS determines whether a SOC of a battery cluster that needs to be calibrated is greater than 50%

No →

S706

The EMS controller monitors whether the energy storage system is currently in a charging or discharging state

Yes

S711

The EMS controller monitors whether the energy storage system is currently in a charging or discharging state

S707

The EMS determines whether the energy storage system is in a discharging state

No

Yes

TO
FIG. 7C

TO
FIG. 7C

TO
FIG. 7C

FIG. 7B

CONT.
FROM
FIG. 7B

CONT.
FROM
FIG. 7B

CONT.
FROM
FIG. 7B

S713

S709

S712

The EMS determines whether the energy storage system is in a charging state

No

The EMS controls the battery cluster that needs to be calibrated to be in a standby state, and controls the battery cluster not to participate in energy storage scheduling control

The EMS controls the battery cluster that needs to be calibrated to participate in discharging within a constraint range of the BMS until the battery cluster satisfies a SOC calibration condition

Yes

S714

S710

The EMS controls the battery cluster that needs to be calibrated to participate in charging within a constraint range of the BMS until the battery cluster satisfies a SOC calibration condition

After completing SOC calibration, the BMS notifies the EMS, so that the calibrated battery cluster participates in normal charging or discharging or standby running

End

FIG. 7C

**EP 4 303 601 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20210083505 A1

- US 2017345101 A1